# EUROPEAN PATENT SPECIFICATION

(11) **EP 0 407 848 B1**
(45) Date of publication and mention of the grant of the patent: **09.06.1999**
(21) Application number: 90112566.6
(22) Date of filing: 02.07.1990
(51) Int. Cl.: H03H 3/00

(54) **trimming method**
Abgleichverfahren
procédé d'ajustage

(30) Priority: 12.07.1989 DE 3922977
(43) Date of publication of application: 16.01.1991
(73) Proprietor: TEXAS INSTRUMENTS DEUTSCHLAND GMBH, 85356 Freising (DE)
(72) Inventor: Steinhagen, Wolfgang, Dr., D-8054 Mauern (DE); Kaiser, Ulrich, D-4788 Warstein 2 - Allagen (DE); Smayling, Michael C., Dr., Missouri City, Texas 77459 (US)
(74) Representative: Schwepfinger, Karl-Heinz, Dipl.-Ing.

(56) References cited:
- FR-A- 2 591 753
- JP-A- 54 134 546
- PATENT ABSTRACTS OF JAPAN, vol. 12, no. 362 (E-663), 28th September 1988; & JP-A-63 116 505 (SEIKO) 20-05-1988
- PATENT ABSTRACTS OF JAPAN, vol. 12, no. 320 (E-651), 30th August 1988; & JP-A-63 086 269 (FUJI) 16-04-1988

## Description

The invention relates to a method of trimming an electrical parameter of an assembly as defined in the precharacterizing part of claims 1 and 2.

Uses exist in electronics in which assemblies must be adjusted by changing the value of an adjustable component. In the adjustment or balancing operation the adjustable component is set to a value which in cooperation with the assembly to be adjusted sets an electrical parameter to a desired value in said assembly. For example, the assembly to be adjusted may be the resonant circuit of a transmitter output stage with which for the purpose of the adjusting a trimming capacitor is connected in parallel which in the balancing operation is set to a value such that a desired resonant frequency of the resonant circuit is achieved. The exact balancing is of great importance in particular when with a small transmitting power a relatively large range is to be achieved, i.e. an optimum energy irradiation. The connection of external components to the assembly to be adjusted is undesirable when the smallest possible space requirement is desired which can only be satisfied when if possible all the components are accommodated in an integrated circuit. Also, connection of external components usually requires the adjusting operation to be carried out by means of mechanical interventions which is time-consuming and therefore undesirable.

In FR-2 591 753 A1 a circuit arrangement is disclosed suitable for adjusting a desired value of an electrical component, wherein the component is made up of a plurality of subcomponents which are connected in parallel with each other and the values of which are in a predetermined relationship to each other. By this circuit arrangement the desired value can be achieved by applying control signals to field-effect transistors inserted into the supply line of each subcomponent. By applying the control signals, a particular interconnection of the subcomponents is created which results in the desired value. However, this desired value only exists as long as the control signals are applied to the field-effect transistors.

The invention is based on the problem of providing a method of the type mentioned at the beginning an electrical parameter of an assembly can be set in simple manner to a desired value.

The trimming method according to the invention is provided with the features of the characterizing part of claim 1. An alternative solution of the trimming method according to the invention is provided with the features of the characterizing part of claim 2. The use of the reference component makes it possible to compensate process influences on the values of the subcomponents which can fluctuate as regards their exact values.

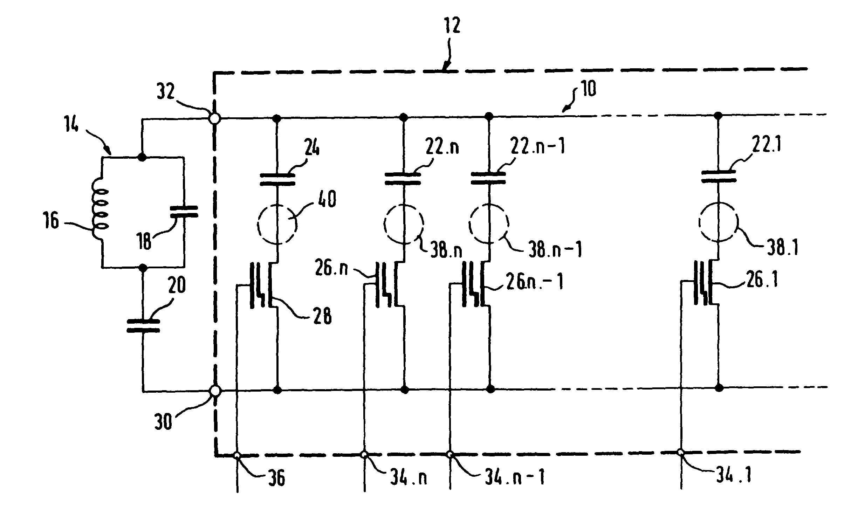

A trimming circuit suitable for carrying out the method of the invention and the method itself will now be explained in detail with the aid of the drawing, the single Figure of which shows a schematic circuit diagram of the trimming circuit.

The trimming circuit 10 illustrated in the drawing is part of an integrated circuit 12 which is shown schematically in the drawing by a dashed outline. The integrated circuit 12 is for example the output stage of a low power transmitter in a transponder which is part of an identification system in which objects to be identified are each provided with their own transponder which can be activated with the aid of an interrogation device and stimulated to transmit an identification code group.

Connected to the integrated circuit 12 is a resonant circuit 14 comprising a coil 16 and two capacitors 18, 20. The coil 16 forms an antenna coil which irradiates the signal to be transmitted. To obtain the best possible irradiation and thus the greatest possible range of the irradiated signals the resonant frequency of the resonant circuit 14 must be adapted as exactly as possible to the transmitted frequency. This can be achieved with the trimming circuit 10.

The trimming circuit 10 includes a plurality of integrated capacitors 22.1 - 22.n which as subcomponents together form a component which is connected to the resonant circuit 14 for adjusting the resonant frequency thereof. The capacitor 24 is a subcomponent like the capacitors 22.1 - 22.n but serves a special purpose which will be explained hereinafter.

A field-effect transistor 26.1 - 26.n, 28 is inserted into each supply line or lead to each of the capacitors 22.122.n and 24. These field-effect transistors are electrically programmable field-effect transistors, i.e. field-effect transistors which by applying a corresponding control signal to their control gate terminal can be put either into the nonconductive state or into the conductive state. Said transistors include a non-connected gate electrode which is referred to in English technical usage as "floating gate". The mode of operation of such transistors is generally known and need not be explained in detail here. The capacitors 22.1 - 22.n are binarily weighted. In the concrete example of embodiment 7 of these transistors are present which have consecutively the values 1C, 2C, 4C, 8C, 16C, 32C and 64C. "C" is the capacitance of the smallest of these capacitors. The capacitor 24 has in the example of embodiment the value 8C. Due to this binary weighting the total value of the capacitors 22.1 - 22.n can be set to any value between 1C and 127C by rendering effective or ineffective with the aid of the field-effect transistors 26.1 - 26.n. This total value plus the value of the capacitor 24 can be connected in parallel to the capacitor 18 of the resonant circuit 14.

In fabrication of the integrated circuit 12 in the course of the testing as preparation for the subsequent use all the transistors 26.1 - 26.n and 28 are put in the conductive state which means that all the capacitors 22.1 - 22.n and 24 are effective and form a total capacitance corresponding to the sum of the partial capacitances. After connection of the resonant circuit 14 to the terminals 30 and 32 of the integrated circuit 12 the following steps are carried out to adjust the resonant frequency.

Due to production tolerances the absolute capacitances of the capacitors contained in the integrated circuit cannot be exactly defined. Since however all the capacitors are made with the aid of the same process steps they also have the same production tolerances and this ensures that the relative relationships defined by the geometry of the capacitors are correct. This means in other words that the capacitance of the capacitor 22.n corresponding to the aforementioned binary weighting is 64 times as great as the capacitance of the transistor 22.1.

In a first step of the adjusting method the resonant frequency with which the resonant circuit 14 oscillates when all the transistors of the trimming circuit 10 are effected are measured. To determine which capacitors must be rendered ineffective in order to obtain a change of the resonant frequency from the actual frequency to the desired frequency the capacitor 24 is first rendered ineffective by blocking the field-effect transistor 28 contained in its supply line. As indicated above, said capacitor 24 as regards its capacitance is in a fixed ratio to the capacitor 22.1; its capacitance is 8 times as great as the capacitance of the capacitor 22.1, Rendering the capacitor 24 ineffective leads to a change of the resonant frequency of the resonant circuit 14, i.e. to an increase because the total capacitance which lies in parallel to the resonant circuit 14 is reduced. From the simple oscillation equation of the resonant circuit 14 it is possible to calculate from the change resulting from disconnection of the capacitor 24 the capacitance change which is necessary for changing the resonant frequency of the resonant circuit 14 from the actual value to the desired value. The calculation can for example show that a change of 65C is necessary to give the desired frequency change. This means that the field-effect transistor 26.1 and the field-effect transistor 26.n must be moved to the nonconductive state so that the capacitor 22.1 and capacitor 22.n, which together have a capacitance of 65C, are rendered ineffective. After blocking these two field-effect transistors 26.1 and 26.n the capacitors of the trimming circuit 10 have exactly the total capacitance which sets the resonant frequency of the resonant circuit 14 to the desired value.

Because of the use of the electrically programmable field-effect transistors in the supply lines to the capacitors of the trimming circuit it is only necessary to apply switching signals to the control inputs 34.1 to 34.n and 36 once because the switching states of the field-effect transistors 26.1 - 26.n and 28 are retained even when the switching signals are no longer applied.

In the embodiment of the trimming circuit described it is assumed that the resonant frequency of the resonant circuit 14 without parallel connection of the capacitors of the trimming circuit is under all circumstances higher than the desired frequency to be achieved. With the aid of the trimming circuit the resonant frequency can then be reduced until the desired frequency is reached.

In a further embodiment it would also be possible to put the field-effect transistors 26.1 - 26.n and 28 into the nonconductive state before the actual use so that initially all the capacitors 22.1 - 22.n and 24 are ineffective. During the adjusting operation in this embodiment the field-effect transistor 28 is then first put into the conductive state so that the capacitor 24 becomes effective and the frequency change which results from the effectiveness of the capacitor 24 in the resonant circuit 14 is determined. It is then possible to calculate from this frequency change which capacitance must be connected in parallel to the resonant circuit 14 to obtain the desired value of the resonant frequency, whereupon the corresponding capacitors 22.1 - 22.n are rendered effective by setting the corresponding field-effect transistors 26.1 to 26.n contained in their supply lines to the conductive state with the aid of switching signals.

In the application of the trimming circuit described above in the output stage of a transmitter relatively high voltage peaks can occur at the capacitors 22.1 - 22.n and 24 and consequently problems regarding the dielectric strength may possibly arise. To overcome these problems additional electrically programmable field-effect transistors 38.1 - 38.n and 40 which are connected in series with the respective field-effect transistors 26.1 - 26.n and 28 may be inserted into the supply lines to the capacitors in each case at the point shown by a dashed-line circle. In the course of the final test of the integrated circuit 12 these additional field-effect transistors are put into the conductive state so that they do not have any influence on the trimming method outlined above. They merely reduce the voltage load of the individual components lying respectively parallel to the resonant circuit 14.

It is pointed out that the trimming circuit described may contain instead of the capacitors 22.1 - 22.n and 24 resistors which can be rendered effective or ineffective to adjust an assembly in which the adjustment can be achieved by parallel connection of a specific resistance. The trimming process would then take place exactly as outlined above in the case of adjusting the resonant frequency of the resonant circuit 14.

## Claims

1. Method of trimming an electrical parameter of an assembly by connecting an electrical component made up of a plurality of subcomponents (22.1 - 22.n) and of a reference component (24) which are connected in parallel with each other and the values of which are in a predetermined relationship to each other, wherein into a supply line to each subcomponent 22.1 - 22.n) and of said reference component (24) at least one electrically programmable field effect transistor (26.1 - 26.n, 28) is inserted which via a control gate terminal can be put permanently into a conductive state or a nonconductive state, characterized in that all the subcomponents 22.1 - 22.n) and a reference component (24) are rendered effective in that the field effect transistors (26.1 - 26.n, 28) inserted into one of their supply lines are put into the conductive state, that the trimming circuit (10) is connected to the assembly (14) and the actual value of the electrical parameter to be adjusted and the deviation thereof from a desired value are determined, that the reference component (24) is rendered ineffective by blocking the field effect transistor (28) inserted into the supply line thereof, that the change of the electrical parameter of the assembly (14) caused by rendering the reference component (24) ineffective is measured, that from the measurement result the magnitude of the value of the subcomponents (22.1 - 22.n) which is to be rendered effective to change the electrical parameter of the assembly (14) to be adjusted from the actual value to the desired value is calculated and that the field effect transistors (26.1 - 26.n) are blocked in as many supply lines to the subcomponents (22.1 - 22.n) as is necessary to reach the calculated value of the subcomponents (22.1 - 22.n) to be rendered ineffective.

2. Method of trimming an electrical parameter of an assembly by connecting an electrical component made up of a plurality of subcomponents (22.1 - 22.n) and of a reference component (24) which are connected in parallel with each other and the values of which are in a predetermined relationship to each other, wherein into a supply line to each subcomponent (22.1 - 22.n) and of said reference component (24) at least one electrically programmable field effect transistor (26.1 - 26.n, 28) is inserted which via a control gate terminal can be put permanently into a conductive state or a nonconductive state, characterized in that in the trimming circuit (10) all the subcomponents (22.1 - 22.n) and the reference component (24) are rendered ineffective in that the field effect transistors (26.1 - 26.n, 28) inserted into one of their supply lines are put into the blocked state, that the trimming circuit (10) is connected to the assembly (14) and the actual value of the electrical parameter to be adjusted and the deviation thereof from a desired value are determined, that the reference component (24) is rendered effective by rendering conductive the field effect transistor (28) inserted into the supply line thereof, that the change of the electrical parameters of the assembly (14) caused by rendering the reference component (24) effective is measured, that from the measurement result the magnitude of the value of the subcomponents (22.1 - 22.n) which is to be rendered ineffective to change the electrical parameter of the assembly (14) to be adjusted from the actual value to the desired value is calculated and that the field effect transistors (26.1 - 26.n) are blocked in as many supply lines to the subcomponents (22.1 - 22.n) as is necessary to reach the calculated value of the subcomponents (22.1 - 22.n) to be rendered effective.

## Patentansprüche

1. Verfahren zum Abgleichen eines elektrischen Parameters einer Anordnung durch Anschließen eines elektrischen Bauelements aus mehreren Teil-Bauelementen (22.1-22.n) und einem Referenz-Bauelement (24), die parallel zueinander geschaltet sind und deren Werte in einer vorbestimmten Beziehung zueinander stehen, wobei in eine Zuleitung zu jedem Teil-Bauelement (22.1-22.n) und zu dem Referenz-Bauelement (24) wenigstens ein elektrisch programmierbarer Feldeffekttransistor (26.1-26.n, 28) eingefügt ist, der über einen Steuer-Gate-Anschluß dauerhaft in einen leitenden oder einen nichtleitenden Zustand versetzt werden kann, dadurch gekennzeichnet, daß alle Teil-Bauelemente (22.1-22.n) und das Referenz-Bauelement (24) dadurch wirksam gemacht werden, daß die in eine ihrer Zuleitungen eingefügten Feldeffekttransistoren (26.1-26.n, 28) in den leitenden Zustand versetzt werden, daß die Trimmschaltung (10) mit der Anordnung (14) verbunden wird und der Istwert des einzustellenden elektrischen Parameters sowie dessen Abweichung von einem Sollwert bestimmt werden, daß das Referenz-Bauelement (24) durch Sperren des in seine Zuleitung eingefügten Feldeffekttransistors (28) unwirksam gemacht wird, daß die durch das Unwirksammachen des Referenz-Bauelements (24) hervorgerufene Änderung des elektrischen Parameters der Anordnung (14) gemessen wird, daß aus dem Meßergebnis die Größe des Werts der Teil-Bauelemente (22.1-22.n) berechnet wird, der wirksam gemacht werden muß, um den elektrischen Parameter der abzugleichenden Anordnung vom Istwert auf den Sollwert zu verändern, und daß die Feldeffekttransistoren (26.1-26.n) in so vielen Zuleitungen zu den Teil-Bauelementen (22.1-22.n) gesperrt werden, wie notwendig ist, um den berechneten Wert der unwirksam zu machenden Teil-Bauelemente (22.1-22.n) zu erreichen.

2. Verfahren zum Abgleichen eines elektrischen Parameters einer Anordnung durch Anschließen eines elektrischen Bauelements aus mehreren Teil-Bauelementen (22.1-22.n) und einem Referenz-Bauelement (24), die parallel zueinander geschaltet sind und deren Werte in einer vobestimmten Beziehung zueinander stehen, wobei in eine Zuleitung zu jedem Teil-Bauelement (22.1-22.n) und zu dem Referenz-Bauelement (24) wenigstens ein elektrisch programmierbarer Feldeffekttransistor (26.1-26.n, 28) eingefügt ist, der über einen Steuer-Gate-Anschluß dauerhaft in einen leitenden oder einen nichtleitenden Zustand versetzt werden kann, dadurch gekennzeichnet, daß in der Trimmschaltung (10) alle Teil-Bauelemente (22.1-22.n) und das Referenz-Bauelement (24) dadurch unwirksam gemacht werden, daß die in eine ihrer Zuleitungen eingefügten Feldeffekttransistoren (26.1-26.n, 28) in den nichtleitenden Zustand versetzt werden, daß die Trimmschaltung (10) mit der Anordnung (14) verbunden wird und der Istwert des einzustellenden elektrischen Parameters sowie dessen Abweichung von einem Sollwert bestimmt werden, daß das Referenz-Bauelement (24) durch Leitendmachen des in seine Zuleitung eingefügten Feldeffekttransistors (28) wirksam gemacht wird, daß die durch das Wirksammachen des Referenz-Bauelements (24) hervorgerufene Änderung des elektrischen Parameters der Anordnung (14) gemessen wird, daß aus dem Meßergebnis die Größe des Werts der Teil-Bauelemente (22.1-22.n) berechnet wird, der unwirksam gemacht werden muß, um den elektrischen Parameter der abzugleichenden Anordnung vom Istwert auf den Sollwert zu verändern, und daß die Feldeffekttransistoren (26.1-26.n) in so vielen Zuleitungen zu den Teil-Bauelementen (22.1-22.n) leitend gemacht werden, wie notwendig ist, um den berechneten Wert der wirksam zu machenden Teil-Bauelemente (22.1-22.n) zu erreichen.

## Revendications

1. Procédé d'ajustement d'un paramètre électrique d'un assemblage en connectant un composant électrique réalisé à partir d'une pluralité de sous-composants (22.1 - 22.n) et d'un composant de référence (24) qui sont connectés en parallèle l'un avec les autres et dont les valeurs sont reliées de façon prédéterminée l'une avec les autres, dans lequel au moins un transistor à effet de champ électriquement programmable (26.1 - 26.n, 28) est inséré dans une ligne d'alimentation de chaque sous-composant (22.1 - 22.n) et dudit composant de référence (24), lesquels transistors peuvent être placés de façon permanente, par l'intermédiaire d'une borne de grille de commande, dans un état conducteur ou un état non conducteur, caractérisé en ce que tous les sous-composants (22.1 - 22.n) et un composant de référence (24) sont rendus efficaces en plaçant dans un état conducteur les transistors à effet de champ (26.1 - 26.n, 28) insérés dans l'une de leur ligne d'alimentation, en ce que le circuit d'ajustement (10) est connecté à l'assemblage (14) et la valeur réelle du paramètre électrique à ajuster et la déviation de ce paramètre à partir d'une valeur désirée sont déterminées, en ce que le composant de référence (24) est rendu inefficace en bloquant le transistor à effet de champ (28) inséré dans sa ligne d'alimentation, en ce que la modification du paramètre électrique de l'assemblage (14) provoquée en rendant le composant de référence (24) inefficace est mesurée, en ce que, à partir du résultat des mesures, l'amplitude de la valeur des sous-composants (22.1 - 22.n) qui doivent être rendus efficaces pour modifier le paramètre électrique de l'assemblage (14) à ajuster, de la valeur réelle vers la valeur désirée, est calculée, et en ce que les transistors à effet de champ (26.1 - 26.n) sont bloqués dans autant de lignes d'alimentation des sous-composants (22.1 - 22.n) qu'il est nécessaire pour atteindre la valeur calculée des sous-composants (22.1 - 22.n) à rendre inefficaces.

2. Procédé d'ajustement d'un paramètre électrique d'un assemblage, en connectant un composant électrique réalisé à partir d'une pluralité de sous-composants (22.1 - 22.n) et d'un composant de référence (24) qui sont connectés en parallèle l'un avec les autres, et dont les valeurs sont reliées de façon prédéterminée l'une avec les autres, dans lequel au moins un transistor à effet de champ électriquement programmable (26.1 - 26.n, 28) est inséré dans une ligne d'alimentation de chaque sous-composants (22.1 - 22.n) et dudit composant de référence (24), lesquels transistors peuvent être placés de façon permanente, par l'intermédiaire d'une borne de grille de commande, dans un état conducteur ou un état non conducteur, caractérisé en ce que dans le circuit d'ajustement (10), tous les sous-composants, (22.1 - 22.n) et le composant de référence (24) sont rendus inefficaces en plaçant à l'état bloqué les transistors à effet de champ (26.1 - 26.n, 28) insérés dans l'une de leur ligne d'alimentation, en ce que le circuit d'ajustement (10) est connecté à l'assemblage (14) et la valeur réelle du paramètre électrique à ajuster et la déviation de ce paramètre à partir d'une valeur désirée sont déterminées, en ce que le composant de référence (24) est rendu efficace en rendant conducteur le transistor à effet de champ (28) inséré dans sa ligne d'alimentation, en ce que la modification des paramètres électriques de l'assemblage (14) provoquée en rendant le composant de référence (24) efficace est mesurée, en ce que, à partir du résultat de mesure, l'amplitude de la valeur des sous-composants (22.1 - 22.n) qui doivent être rendus efficaces pour modifier le paramètre électrique de l'assemblage (14) à ajuster, de la valeur réelle vers la valeur désirée est calculée, et en ce que les transistors à effet de champ (26.1 - 26.n) sont placés dans l'état conducteur dans autant de lignes d'alimentation des sous-composants (22.1 - 22.n) qu'il est nécessaire pour atteindre la valeur calculée des sous-composants (22.1 - 22.n) à rendre efficaces.
